# EUROPEAN PATENT APPLICATION

(11) **EP 4 230 708 A1**
(43) Date of publication of application: **23.08.2023**
(21) Application number: 21879472.5
(22) Date of filing: 14.10.2021
(51) Int. Cl.: C09K 11/06, H01L 51/00

(54) **LIGHT-EMITTING DEVICE AND USE THEREOF IN DISPLAY**

(30) Priority: 14.10.2020 CN 202011099557
(71) Applicant: Zhejiang Brilliant Optoelectronic Technology Co., Ltd., Taizhou, Zhejiang 318020 (CN)
(72) Inventor: MIN, Chao, Zhejiang 318020 (CN); LIANG, Chacai, Zhejiang 318020 (CN); PAN, Caifa, Zhejiang 318020 (CN)
(74) Representative: Plavsa & Plavsa D.O.O
(86) International application number: PCT/CN2021/123754
(87) International publication number: WO 2022/078429

(57) **Abstract**

The present invention relates to light emitting devices containing an electroluminescent unit that emits light of wavelength I and a colour conversion layer that absorbs the light of wavelength I and emits the light of wavelength II, wherein the colour conversion layer comprises at least one colour conversion material having a structural unit of formula (1) or (2). The color conversion material has a narrow photoluminesent emission spectrum, and the corresponding color conversion layer emits light with small FWHM while absorbing excitation light with a large FWHM. Furthermore, the emission peak of the color conversion materials can be tuned by modifying its molecular structure. A variety of color conversion layers can be prepared using color conversion materials with different structures to emit in different colors such as red, green and blue. Display devices with high color gamut can thus be manufactured by the above-mentioned light emitting devices with narrow emission spectra in different colors.

## Description

### Technical Field

The present invention relates to narrow full width at half maximum(FWHM) light emitting devices and their uses in displays.

### Background

According to the principles of colourimetry, the narrower the FWHMs of the lights perceived by human eyes are, the higher the colour purity, and thus the more vivid the colour display would be. Display devices with narrow-FWHM red, green and blue primary light are able to show vivid views with high colour gamut and high visual quality.

The current mainstream full-colour displays are achieved mainly in two ways. The first method is to actively emit red, green and blue lights, typically such as RGB-OLED display, RGB-Micro-LED display, etc. Due to the need of manufacturing light emitting devices of all three colours, the complexity of processing leads to low yields, and the high-resolution display over 800 ppi is difficult to realize. The second method is to use colour converters to convert the single-colour light from the light emitting devices into different colours, thereby achieving a full-colour display. In this case, the fabrication of the light emitting devices is much simpler, and thus higher yield. Furthermore, the manufacture of the colour converters can be achieved by different technologies, such as vapor deposition, inkjet printing, transfer printing and photolithography, etc., appliable to a variety of display products with very different resolution requirements, all the way from low resolution large-size TV (around only 50ppi) to high resolution silicon-based micro-display (over 4000ppi).

Currently, there are mainly two types of colour conversion materials used in mainstream colour converters. The first one is organic dyes, comprising various organic conjugated small molecules or polymers with chromophores. Due to the lack of rigidity in the molecular structures, intra-molecular thermal relaxations are always non-negligible, leading to the large FWHMs (typically over 60 nm) of their emission spectra. The second one is inorganic nanocrystals, commonly known as quantum dot, which are nanoparticles of inorganic semiconductor material (InP, CdSe, CdS, ZnSe, etc. ) with a diameter of 2-8 nm. The small size of these materials leads to quantum confinement effects, resulting in photoluminescent emissions with a specific frequency, which are highly dependent on the particle size. In this sense, the colour of their emission can be readily tuned by adjusting the sizes. Limited by the current synthesis and separation technology of quantum dots, FWHMs of CD-containing quantum dots typically range from 25 to 40 nm, which meets the display requirements of NTSC for colour purity. Meanwhile, Cd-free quantum dots generally come with larger FWHMs of 55-75 nm. Since Cd is considered highly hazardous to environment and human health, most countries have prohibited the use of Cd-containing quantum dots to produce electronic products. In addition, because the not-sufficiently-large extinction coefficient of quantum dots, the rather thick film required for complete colour conversion is rather high.

Therefore, new colour conversion materials still need to be further developed, in order to meet the requirements of full-colour display.

### Summary

In view of the above deficiencies of the prior art, a main object of the present invention is to provide a light emitting device with a narrow FWHM, and the FWHM of the emitted light of the disclosed narrow-FWHM light emitting device is generally less than 40 nm, preferably less than 35 nm, more preferably less than 30 nm, and most preferably less than 28 nm.

A further object of the present invention is to provide a multi-colour display device utilizing the narrow-FWHM light emitting device, which has an excellent colour gamut.

The technical solution of the present invention is described as follows:
The present invention provides a light emitting device, comprising an electroluminescent unit and a colour conversion layer (CCL), wherein the colour conversion layer comprises at least one colour conversion material (CCM) having a structural unit of formula (1) or (2): 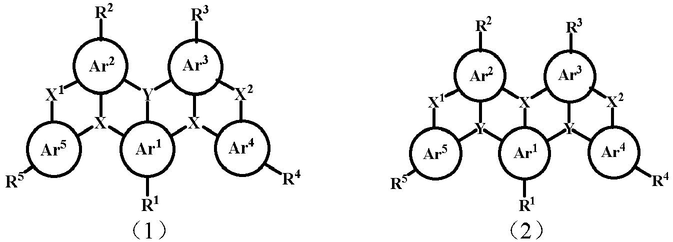 wherein:
each X is selected from N, C(R⁶), Si(R⁶); each Y is selected from B, P=O, C(R⁶), Si(R⁶);
each of Ar¹ to Ar³ is independently selected from an aromatic group containing 5 to 24 ring atoms, or a heteroaromatic group containing 5 to 24 ring atoms;
each of Ar⁴ and Ar⁵ is independently selected from null, an aromatic group containing 5 to 24 ring atoms, or a heteroaromatic group containing 5 to 24 ring atoms;
when neither Ar⁴ nor Ar⁵ is null, each X is selected from N, C(R⁶), or Si(R⁶) , each Y is selected from B, P=O, C(R⁶), or Si(R⁶);
when Ar⁴ and/ or Ar⁵ is null, the corresponding X and Y are each independently selected from N(R⁶), C(R⁶R⁷), Si(R⁶R⁷), C=O, O, C=N(R⁶), C=C(R⁶R⁷), P(R⁶), P(=O)R⁶, S, S=O, or SO₂;
each of X¹ and X² is independently null or a bridging group, and preferably can be independently selected from null, single bond, N(R⁶), C(R⁶R⁷), Si(R⁶R⁷), O, C=N(R⁶), C=C(R⁶R⁷), P(R⁶), P(=O)R⁶, S, S=O, or SO₂;
R¹ to R⁷ are independently selected from the group consisting of H, D, -F, -Cl, Br, I, -CN, -NO₂, -CF₃, B(OR₂)₂, Si(R₂)₃, a C₁-C₂₀ linear alkyl group, a C₁-C₂₀ linear haloalkyl group, a C₁-C₂₀ linear alkoxy group, a C₁-C₂₀ linear thioalkoxy group, a C₃-C₂₀ branched/ cyclic alkyl group, a C₃-C₂₀ branched/ cyclic haloalkyl group, a C₃-C₂₀ branched/ cyclic alkoxy group, a C₃-C₂₀ branched/ cyclic thioalkoxy group, a C₃-C₂₀ branched/ cyclic silyl group, a C₁-C₂₀ ketone group, a C₂-C₂₀ alkoxycarbonyl group, a C₇-C₂₀ aryloxycarbonyl group, a cyano group (-CN), a carbamoyl group (-C(=O)NH₂), a haloformyl group (-C(=O)-X where X denotes a halogen atom), a formyl group (-C(=O)-H), an isocyano group, an isocyanate group, a thiocyanate/ isothiocyanate group, a hydroxyl group, a nitro group, a CF₃ group, a substituted/ unsubstituted aromatic! heteroaromatic group containing 5 to 40 ring atoms, an aryloxy/ heteroaryloxy group containing 5 to 40 ring atoms, an arylamine or heteroarylamine group containing 5 to 40 ring atoms, and a disubstituted unit in any position of the above substituents or any combination thereof, wherein one or more of the substituent groups can form a monocyclic or polycyclic aliphatic or aromatic ring system with each other and/or with the ring bonded to the groups.

In addition or alternatively, the electroluminescent unit is selected from: an OLED (organic light emitting diode), a TFT-LCD (thin-film transistor liquid crystal display), a LED (light emitting diode), a QLED (quantum dot light emitting diode), an OLEC (organic light emitting electrochemical cell), an OLET (organic light emitting transistor), a PeLED (perovskite light emitting diode), a micro-LED (micro-light emitting diode), or other light emitting devices.

In addition or alternatively, the colour conversion layer (CCL) can absorb the light of wavelength I and emit the light of wavelength II.

In addition or alternatively, the emission spectrum of the electroluminescent unit at least partially overlaps with the absorption spectrum of the colour conversion material.

In addition or alternatively, the electroluminescent unit emits UV or blue light.

In addition or alternatively, the FWHM of the spectrum of wavelength II emitted by the colour conversion layer is less than 40 nm.

In addition or alternatively, the colour conversion layer can be either an uniform thin layer or a patterned thin layer with a thickness of 20 nm to 20 µm.

In addition or alternatively, the colour conversion layer can be prepared by vapor deposition, ink-jet printing, screen printing, gravure printing, or post-coating photolithography.

The present invention further provides a display device, comprising a number of sub-pixels, while at least one of the sub-pixels comprises the light emitting device.

Beneficial effects: the colour conversion materials of the present invention includes boron and nitrogen-based compounds with rigid structure, having relatively narrow emission peak, thus providing a new solution for high-colour-purity display. The boron and nitrogen-based compounds show relatively higher extinction coefficient, thereby allowing a thinner device structure. Furthermore, the boron and nitrogen-based compounds are suitable for preparing printing ink, thereby simplifying the device manufacturing process.

### Embodiments

The present invention provides a light emitting device and application thereof. In order to make the objects, technical solutions, and effects of the present invention more clear and definite, the present invention is further described in details below. It should be understood that the embodiments described herein are only intended to explain the present invention, and are not intended to limit the present invention.

As used herein, the terms "formulation", "printing ink" and "inks" have the same meaning, and they are interchangeable with each other.

As used herein, the terms "host material", "matrix material" have the same meaning, and they are interchangeable with each other.

As used herein, the term "substituted" means that a hydrogen atom of the compound is substituented.

As used herein, the term "the number of ring atoms" means that the number of atoms constituting the ring itself of a structural compound (e. g., a monocyclic compound, a fused ring compound, a cross-linked compound, a carbocyclic compound, and a heterocyclic compound) by covalent bonding. When the ring is substituted with a substituent, the atoms contained in the substituent are not included in the ring atoms. The above rule applies for all cases without further specfic description. For example, the number of ring atoms of a benzene ring is 6, the number of ring atoms of a naphthalene ring is 10, and the number of ring atoms of a thienyl group is 5.

The present invention provides a light emitting device, comprising an electroluminescent unit and a colour conversion layer (CCL), wherein the colour conversion layer comprises at least one colour conversion material (CCM) having a structural unit of formula (1) or (2) : 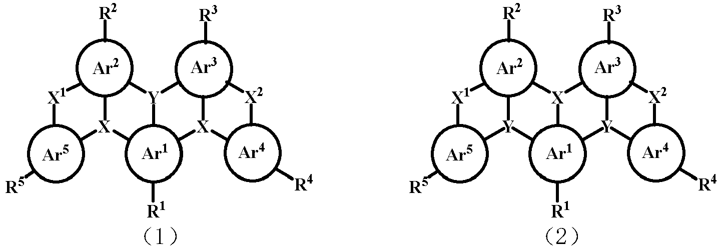 wherein:
each X is selected from N, C(R⁶), Si(R⁶); each Y is selected from B, P=O, C(R⁶), Si(R⁶);
each of Ar¹ to Ar³ is independently (same or differently) selected from an aromatic group containing 5 to 24 ring atoms, or a heteroaromatic group containing 5 to 24 ring atoms;
each of Ar⁴ and Ar⁵ is independently (same or differently) selected from null, an aromatic group containing 5 to 24 ring atoms, or a heteroaromatic group containing 5 to 24 ring atoms;
when neither Ar⁴ nor Ar⁵ is null, each X is selected from N, C(R⁶), or Si(R⁶), each Y is selected from B, P=O, C(R⁶), or Si(R⁶);
when either Ar⁴ and/ or Ar⁵ is null, the corresponding X and Y are each independently selected from N(R⁶), C(R⁶R⁷), Si(R⁶R⁷), C=O, O, C=N(R⁶), C=C(R⁶R⁷), P(R⁶), P(=O)R⁶, S, S=O, or SO₂;
each of X¹ and X² is independently null or a bridging group, and preferably can be independently selected from null, single bond, N(R⁶), C(R⁶R⁷), Si(R⁶R⁷), O, C=N(R⁶), C=C(R⁶R⁷), P(R⁶), P(=O)R⁶, S, S=O, or SO₂;
R¹ to R⁷ are independently selected from the group consisting of H, D, -F, -Cl, Br, I, -CN, -NO₂, -CF₃, B(OR₂)₂, Si(R₂)₃, a C₁-C₂₀ linear alkyl group, a C₁-C₂₀ linear haloalkyl group, a C₁-C₂₀ linear alkoxy group, a C₁-C₂₀ linear thioalkoxy group, a C₃-C₂₀ branched/ cyclic alkyl group, a C₃-C₂₀ branched/ cyclic haloalkyl group, a C₃-C₂₀ branched/ cyclic alkoxy group, a C₃-C₂₀ branched/ cyclic thioalkoxy group, a C₃-C₂₀ branched/ cyclic silyl group, a C₁-C₂₀ ketone group, a C₂-C₂₀ alkoxycarbonyl group, a C₇-C₂₀ aryloxycarbonyl group, a cyano group (-CN), a carbamoyl group (-C(=O)NH₂), a haloformyl group (-C(=O)-X where X denotes a halogen atom), a formyl group (-C(=O)-H), an isocyano group, an isocyanate group, a thiocyanate/ isothiocyanate group, a hydroxyl group, a nitro group, a CF₃ group, a substituted/ unsubstituted aromatic! heteroaromatic group containing 5 to 40 ring atoms, an aryloxy/ heteroaryloxy group containing 5 to 40 ring atoms, an arylamine or heteroarylamine group containing 5 to 40 ring atoms, and a disubstituted unit in any position of the above substituents or a combination thereof, wherein one or more of the substituent groups can form a monocyclic or polycyclic aliphatic or aromatic ring system with each other and/or with the ring bonded to the groups.
Ar¹ to Ar⁵, in multiple occurrences, are independently selected from aromatic groups containing 2 to 24 carbon atoms, such as benzene, biphenyl, triphenylbenzene/triphenylene, benzphenanthrene, naphthalene, anthracene, phenalene, phenanthrene, fluorene, pyrene, chrysene, perylene, chrysene; or Ar¹ to Ar⁵ are independently selected from heteroaromatic groups containing 2 to 24 carbon atoms, such as furan, thiophene, pyrrole, benzofuran, benzothiophene, dibenzothiophene, dibenzofuran, carbazole, pyrazole, imidazole, triazole, isoxazole, thiazole, oxadiazole, oxatriazole, oxadiazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, phthalazine/cinnoline, quinazoline, quinoxaline, naphthalene, phthalide, pteridine, xanthene, acridine, phenazine, phenothiazine, phenazine, dibenzoselenophene, benzoselenophene, benzofuropyridine, indolocarbazole, pyridylindole, pyrrolodipyridine, furodipyridine, benzothienopyridine, thienodipyridine, benzoselenophenopyridine or selenophenodipyridine. In a preferred embodiment, Ar¹ to Ar⁵ are independently selected from functional groups containing 2 to 10 ring atoms, which may be the same or different cyclic aromatic hydrocarbon groups/ aromatic heterocyclic groups, and these groups are linked to one another directly or through at least one of the following groups, such as O, N, S, Si, P, B, chain structural units and aliphatic ring groups; wherein Ar¹, Ar², Ar³, Ar⁴, Ar⁵ can be further substituted independently by one or more R¹ to R⁵ groups respectively, or unsubstituted.

The term "aromatic group" refers to a hydrocarbon group consisting of at least one aromatic ring, including monocyclic groups and polycyclic systems. The term "heteroaromatic group" refers to a heteroaromatic group consisting of at least one heteroaromatic ring, including monocyclic groups and polycyclic systems. The polycyclic systems contain two or more rings, in which two carbon atoms are shared by two adjacent rings, i.e. fused ring. Specifically, at least one of the rings in the polycyclic rings are aromatic or heteroaromatic. For the purposes of the present invention, the aromatic ring groups or heteroaromatic groups comprise not only aromatic or heteroaromatic systems, but also fused functional groups in which a plurality of aryl or heteroaryl groups are interconnected by short non-aromatic units (for example by <10% of non-H atoms, more specifically 5% of non-H atoms, such as C, N or O atoms). Therefore, systems such as 9,9'-spirobifluorene, 9,9-diaryl fluorene, triarylamine, diaryl ethers, and other systems, should also be considered as aromatic groups for the purposes of this invention.

Specifically, preferred examples of the aromatic groups include: benzene, naphthalene, anthracene, phenanthrene, perylene, tetracene, pyrene, benzopyrene, triphenylene, acenaphthylene, fluorene, and their derivatives thereof.

Specifically, preferred examples of heteroaromatic groups include : furan, benzofuran, thiophene, benzothiophene, pyrrole, pyrazole, triazole, imidazole, oxazole, oxadiazole, thiazole, tetrazole, indole, carbazole, pyrroloimidazole, pyrrolopyrrole, thienopyrrole, thienothiophene, furopyrrole, furofuran, thienofuran, benzisoxazole, benzisothiazole, benzimidazole, pyridine, pyrazine, pyridazine, pyrimidine, triazine, quinoline, isoquinoline, o-diazonaphthalene, quinoxaline, phenanthridine, pyrimidine, quinazoline, quinazolinone, and their derivatives thereof.

In a preferred embodiment, in the organic compounds described by the present invention, the Ar¹ to Ar⁵ denote aromatic groups or heteroaromatic groups with 5 to 22 C atoms; in a more preferred embodiment, the Ar¹ to Ar⁵ denote aromatic groups or heteroaromatic groups with 5 to 20 C atoms; in a further preferred embodiment, the Ar¹ to Ar⁵ denote aromatic or heteroaromatic groups with 5 to 18 C atoms.

In a preferred embodiment, in the organic compound described by the present invention, the Ar¹ to Ar⁵ may comprise one or combinations of more than one of the following structural groups: 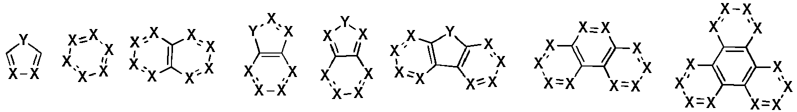 wherein:
X at each occurrence, can independently be N or CR₅;
Y at each occurrence, can be independently selected from CR₆R₇, SiR₆R₇, NR₆, C(=O), S, or O;
R₅, R₆ and R₇ are independently defined as R¹.

Further, each of the Ar¹ to Ar⁵ is independently selected from one or combinations of more than one of the following structural formulae, which can be further optionally substituted: 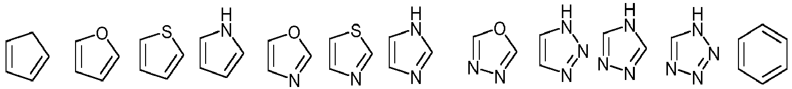 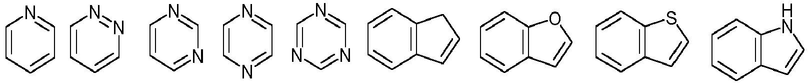 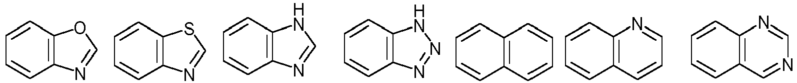 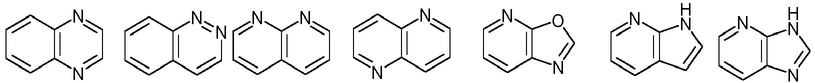 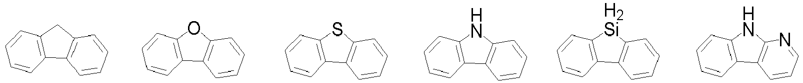 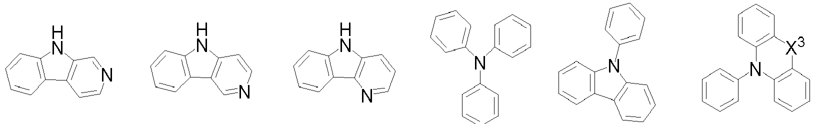 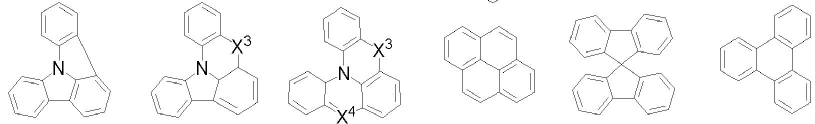 wherein each of X³ and X⁴ is independently null or a bridging group.

In a preferred embodiment, the colour conversion layer comprises at least one colour conversion material (CCM) having a structural unit of formula (1a) or (2a): 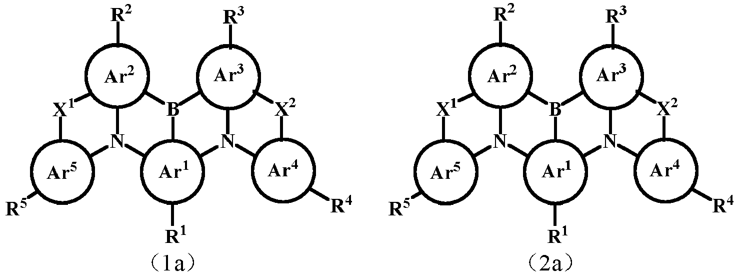 wherein Ar¹ to Ar⁵ , R¹ to R⁵, X¹ to X² are same as those defined above.

In certain preferred embodiments, at least one of the bridging groups X¹ or X² is null; particularly preferably, both are null, in which case the compound comprises a structural unit of formula (1b) or (2b):

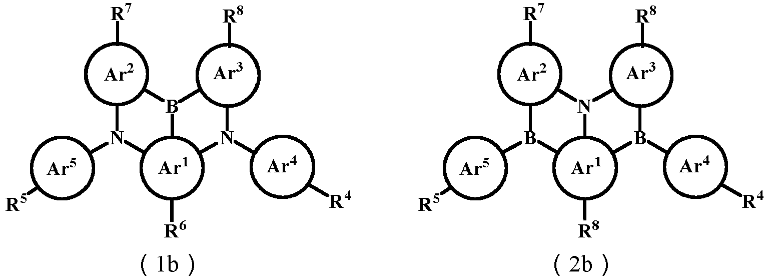

In some preferred embodiments, at least one of X¹ or X² is a single bond; particularly preferably, both are single bonds, and the compound comprises a structural unit of formula (1c) or (2c):

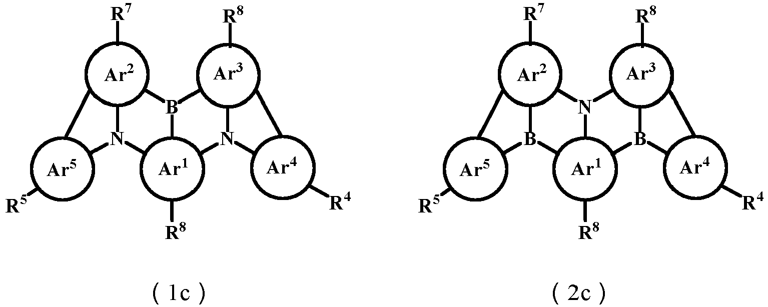

In certain embodiments, X¹, X² at each occurrence are the same or different di-bridging group; the preferred di-bridging groups are the following formulae:

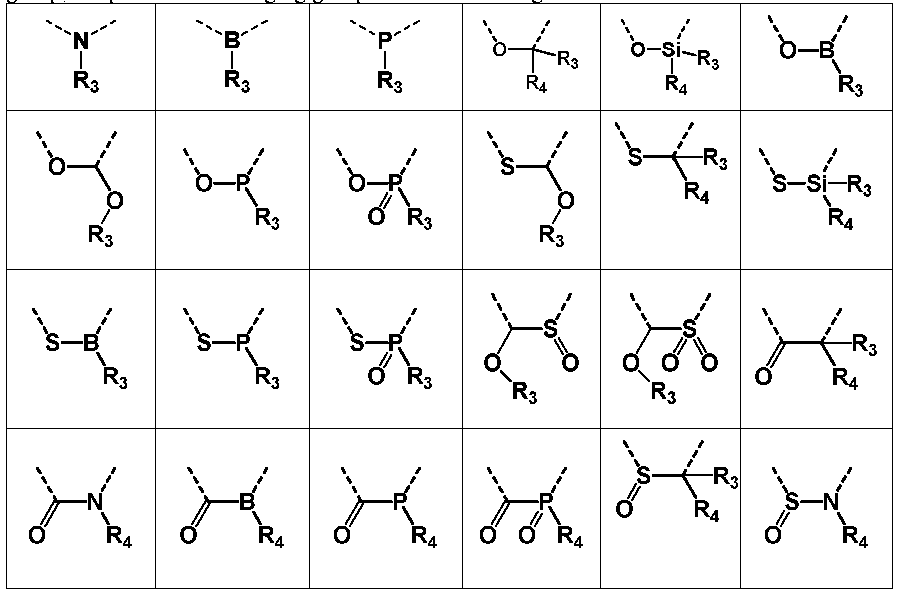

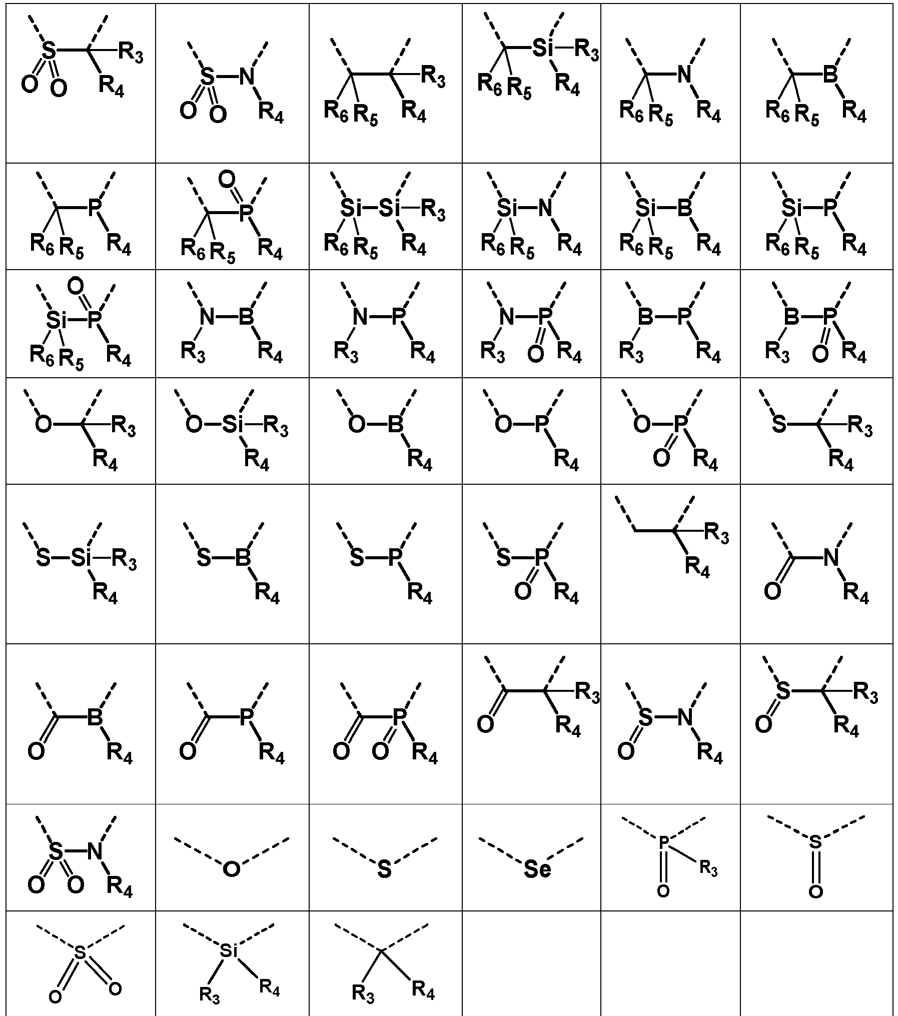

wherein R³, R⁴, R⁵ and R⁶ are identically defined as the above-mentioned R¹, and the dashed bonds refer to the covalent bonds connecting to the adjacent structural units.

For the purposes of the present invention, the aromatic ring systems contain 5 to 10 carbon atoms in the ring systems, the heteroaromatic ring systems contain 1 to 10 carbon atoms and at least one heteroatom in the ring systems, while the total number of carbon atoms and heteroatoms is at least 4. The heteroatoms are preferably selected from Si, N, P, O, S and/ or Ge, particularly preferably selected from Si, N, P, O and/ or S. For the purposes of the present invention, the aromatic ring groups or heteroaromatic groups contain not only aromatic or heteroaromatic systems, but also functional groups in which a plurality of aryl or heteroaryl groups are interconnected by short non-aromatic units (for example by <10% of non-H atoms, more specifically 5% of non-H atoms, such as C, N or O atoms). Therefore, systems such as 9,9'-spirobifluorene, 9,9-diaryl fluorene, triarylamine, diaryl ethers, and the like are also considered to be aromatic ring systems for the purpose of this disclosure.

For the purposes of the present invention, the any H atom on the compound may be optionally substituted with a R¹ group, wherein the preferred R¹ may be selected from (1) a C1 to C10 alkyl group, particularly preferred as the following groups: methyl, ethyl, n-propyl, isopropyl, cyclopropyl, n-butyl, isobutyl, sec-butyl, t-butyl, cyclobutyl, 2-methylbutyl, n-pentyl, n-hexyl, cyclohexyl, n-heptyl, cycloheptyl, n-octyl, cyclooctyl, 2-ethylhexyl, trifluoromethyl, pentafluoromethyl, 2,2,2-trifluoroethyl, vinyl, propenyl, butenyl, pentenyl, cyclopentenyl, hexenyl, cyclohexenyl, heptenyl, cycloheptenyl, octenyl, cyclooctenyl, ethynyl, propynyl, butynyl, pentynyl, hexynyl, or octynyl; (2) a C1 to C10 alkoxy group, particularly preferably methoxy, ethoxy, n-propoxy, isopropoxy, n-butoxy, isobutoxy, sec-butoxy, tert-butoxy or 2-methylbutoxy; (3) a C2 to C10 aryl or heteroaryl group, which may be monovalent or divalent depending on the application, and in each case can also be optionally substituted with the group R¹ mentioned above or may be attached, at any desired position, to an aromatic or heteroaromatic ring, particularly preferably selected from: benzene, naphthalene, anthracene, dihydropyrene, chrysene, pyrene, fluoranthene, naphthacene, pentacene, benzopyrene, furan, benzofuran, isobenzofuran, dibenzofuran, thiophene, benzothiophene, isobenzothiophene, thiofluorene, pyrrole, indole, isoindole, carbazole, pyridine, quinoline, isoquinoline, acridine, phenanthridine, benzo-5,6-quinoline, benzo-6,7-quinoline, benzo-7,8-quinoline, phenothiazine, phenoxazine, pyrazole, indazole, imidazole,benzimidazole, naphthimidazole, phenimidazole, pyridimidazole, pyrazine-imidazole, quinoxaline-imidazole, oxazole, benzoxazole, naphthoxazole, anthracenazole, phenoxazole, isoxazole, 1,2-thiazole, 1,3-thiazole, benzothiazole, pyridazine, benzopyridazine, pyrimidine, benzopyrimidine, quinoxaline, pyrazine, phenazine, 1,5-naphthyridine, carbazole, benzocholine, phenanthroline, 1,2,3-triazole, 1,2,4-triazole, benzotriazole, 1,2,3-oxadiazole, 1,2,4-oxadiazole, 1,2,5-oxadiazole, 1,3,4-oxadiazole, 1,2,3-thiadiazole, 1,2,4-thiadiazole, 1,2,5-thiadiazole, 1,3,4-thiadiazole, 1,3,5-triazine, 1,2,4-triazine, 1,2,3-triazine, tetrazole. 1,2,4,5-tetrazine, 1,2,3,4-tetrazine, 1,2,3,5-tetrazine, purine, pteridine, indolizine and benzothiadiazole. For the purposes of the present disclosure, aromatic and heteroaromatic ring systems are particularly considered to be, in addition to the above-mentioned aryl and heteroaryl groups, biphenylene, terphenylene, fluorene, spirofluorene, dihydrophenanthrene, tetrahydropyrene, cis-indenofluorene, or trans-indenofluorene.

In a preferred embodiment, the compounds of the present invention, wherein Ar¹ to Ar⁵ are identical or different at each occurrence and are independently selected from the group consisting of aromatic! heteroaromatic groups with 5 to 20, preferably 5 to 18, more preferably 5 to 15, and most preferably 5 to 10 ring atoms; they may be unsubstituted or further substituted by one or two R¹ groups. Preferred aromatic! heteraromatic groups include benzene, naphthalene, anthracene, phenanthrene, pyridine, pyrene, and thiophene.

For the purposes of the present invention, in a particularly preferred embodiment, each of Ar¹ to Ar⁵ is phenyl in the structural units of formulae (1)-(1e) or (2)-(2e).

In a particularly preferred embodiment, the compound comprises a structural unit of formula (1a) or (2a):

| | |
|---|---|
| 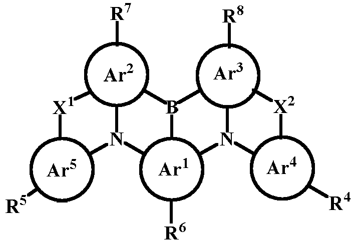 | 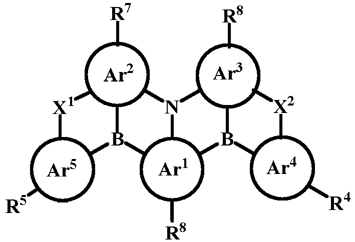 |
| (1a) | (2a) |

wherein each of X¹ and X² is O or S, and particularly preferably is O.

In another particularly preferred embodiment, the compound comprises a structural unit of formula (1d) , (2d) , (1e), or (2e):

| | |
|---|---|
| 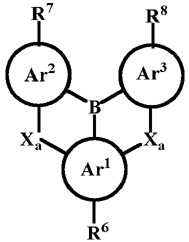 | 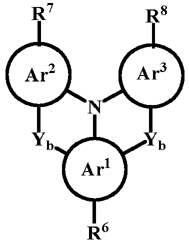 |
| (1d) | (2d) |
| 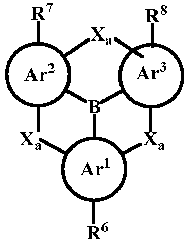 | 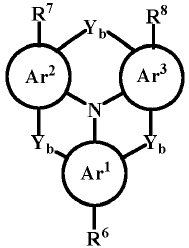 |
| (1e) | (2e) |

Preferably, each Y_{b} in the formulae (2d) and (2e) are each independently selected from C=O, O, P(=O)R⁹, S=O, or SO₂; and particularly preferably from C=O.

Preferably, each Xₐ in the formulae (1d) and (1e) are each independently selected from N(R⁹), C(R⁹R¹⁰), Si(R⁹R¹⁰), O, or S.

In a particularly preferred embodiment, the compound has the structure shown below: 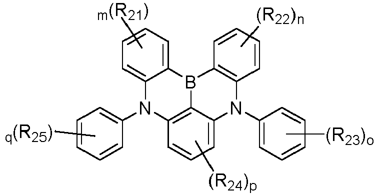 wherein R₂₁-R₂₅ are independently selected from the group consisting of H, D, a C₁-C₂₀ linear alkyl group, a C₁-C₂₀ linear alkoxy group, a C₁-C₂₀ linear thioalkoxy group, a C₃-C₂₀ branched/ cyclic alkyl group, a C₃-C₂₀ branched/ cyclic alkoxy group, a C₃-C₂₀ branched/ cyclic thioalkoxy group, a C₃-C₂₀ branched/ cyclic silyl group, a C₁-C₂₀ ketone group, a C₂-C₂₀ alkoxycarbonyl group, a C₇-C₂₀ aryloxycarbonyl group, a cyano group (-CN), a carbamoyl group (-C(=O)NH₂), a haloformyl group (-C(=O)-X where X denotes a halogen atom), a formyl group (-C(=O)-H), an isocyano group, an isocyanate group, a thiocyanate/ isothiocyanate group, a hydroxyl group, a nitro group, a CF₃ group, Cl, Br, F, a substituted/ unsubstituted aromatic! heteroaromatic group containing 5 to 40 ring atoms, an aryloxy/ heteroaryloxy group containing 5 to 40 ring atoms, and any combination thereof, wherein one or more of the substituent groups can form a monocyclic or polycyclic aliphatic or aromatic ring system with each other and/ or with the ring bonded to the groups; m, n are integers from 0 to 4; o, q are integers from 0 to 5; p is an integer from 0 to 3.

In a particularly preferred embodiment, the colour conversion material of the light emitting device according to the present invention is preferably selected from, but not limited to the following structural formulae:

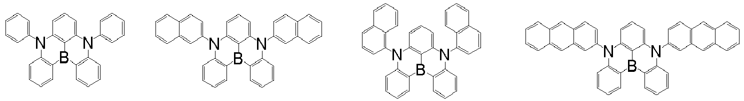

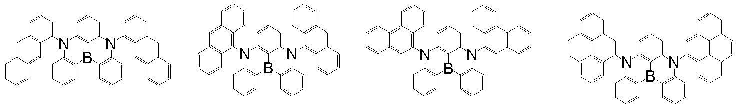

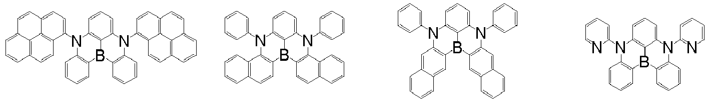

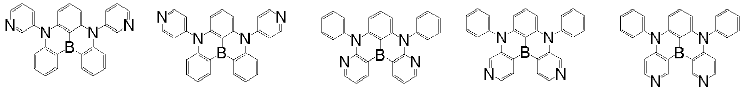

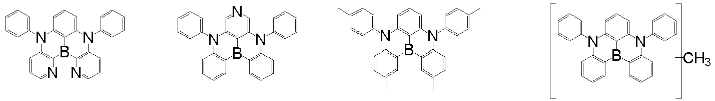

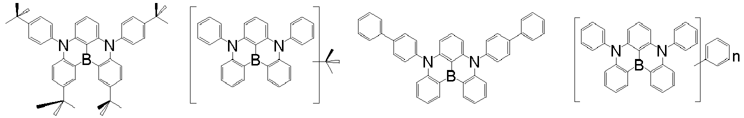

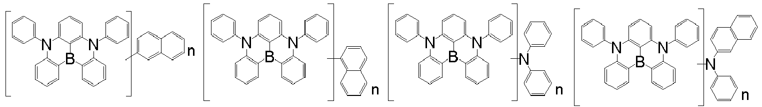

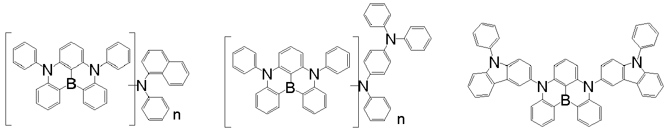

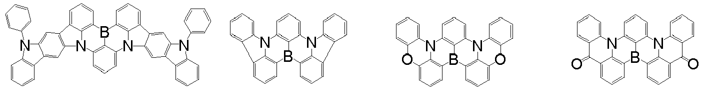

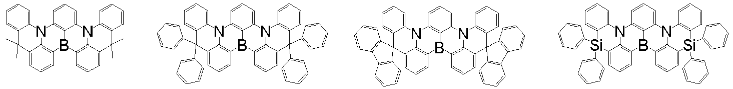

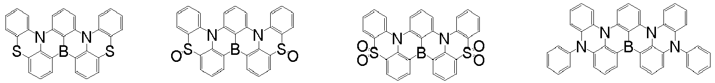

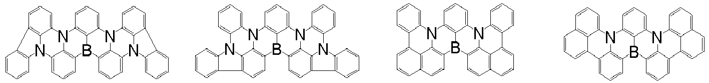

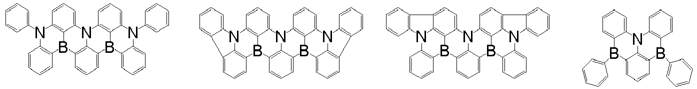

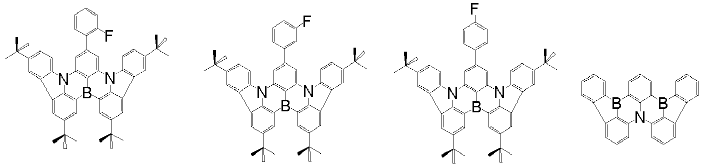

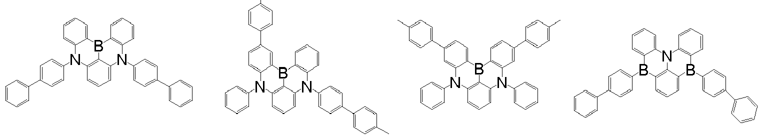

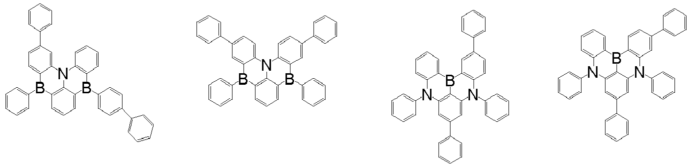

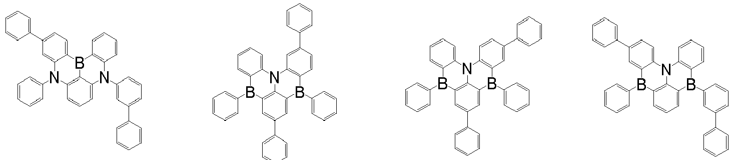

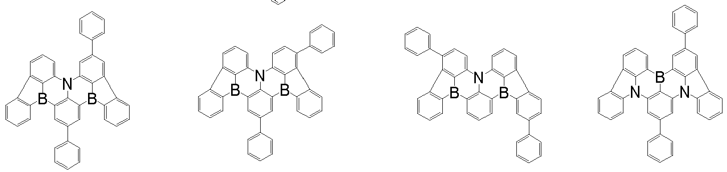

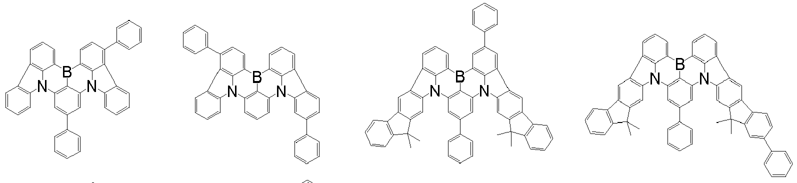

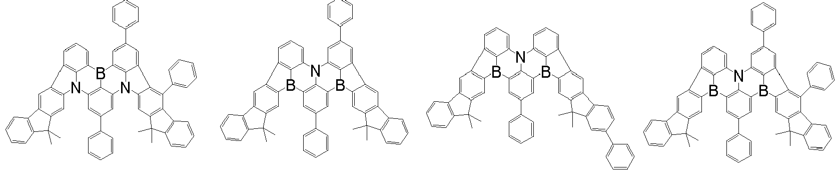

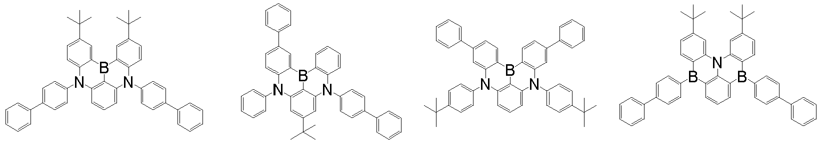

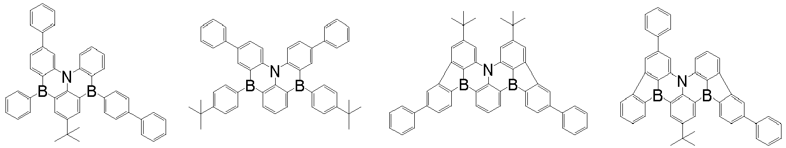

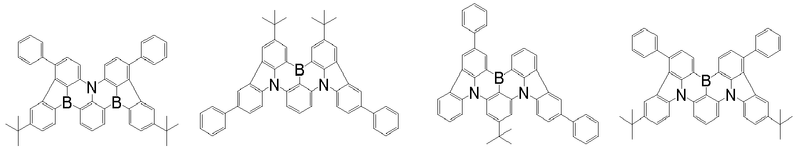

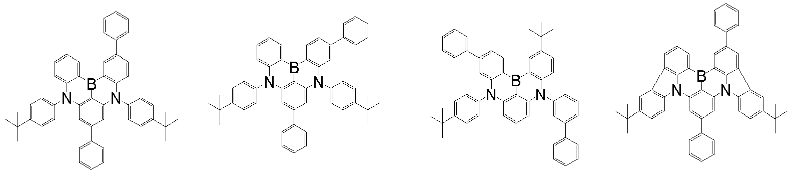

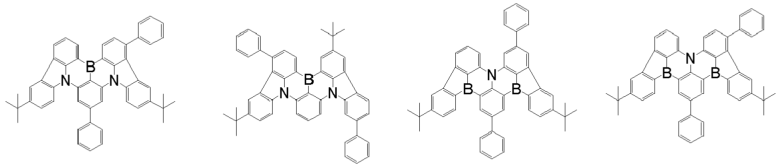

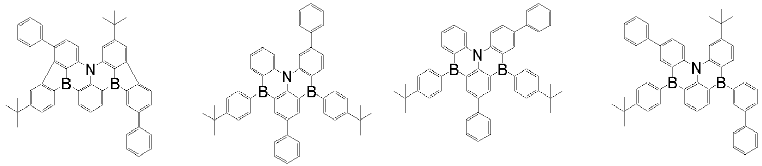

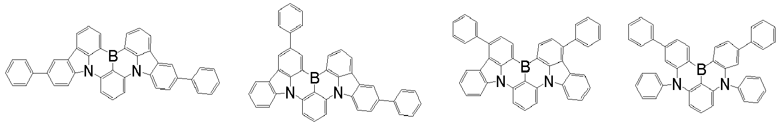

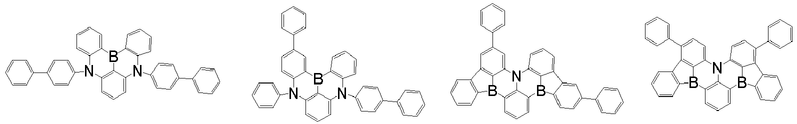

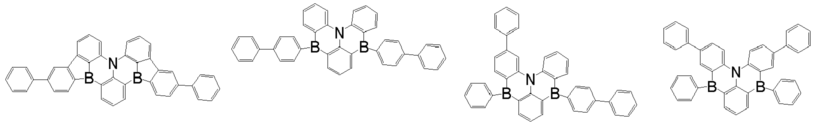

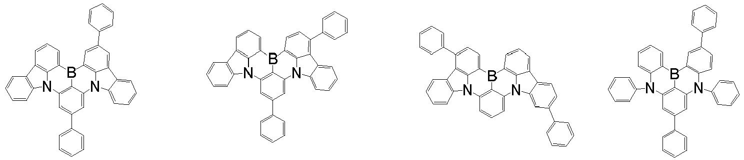

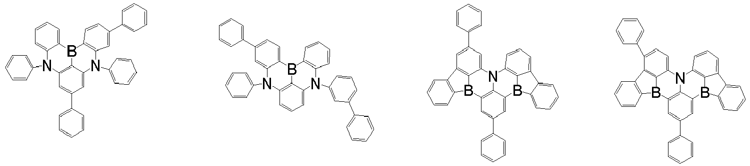

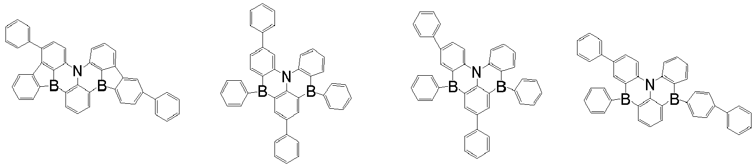

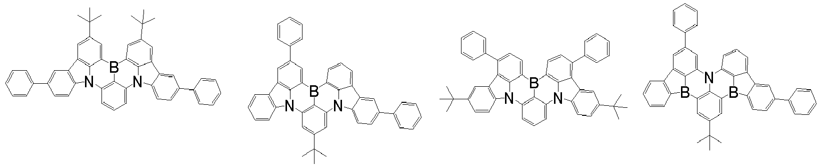

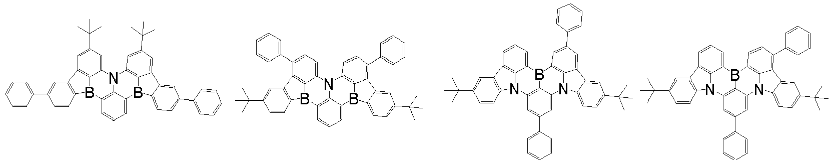

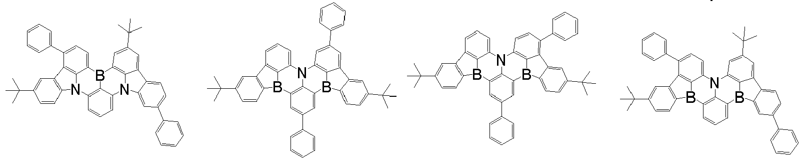

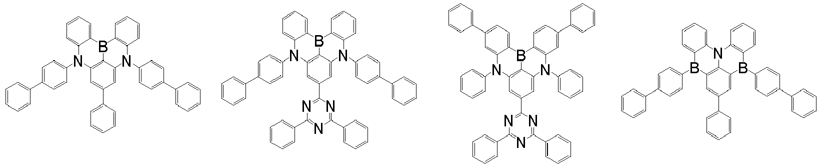

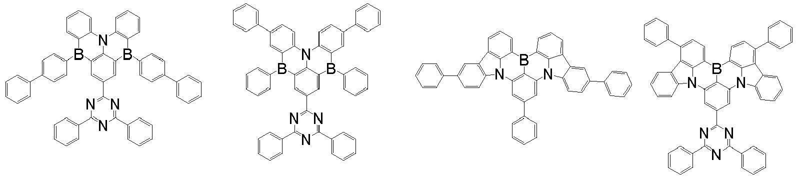

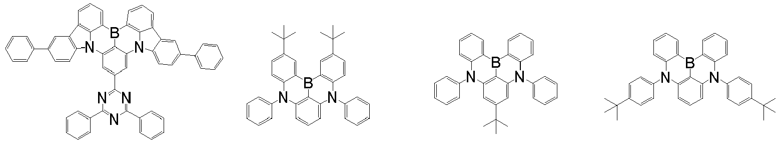

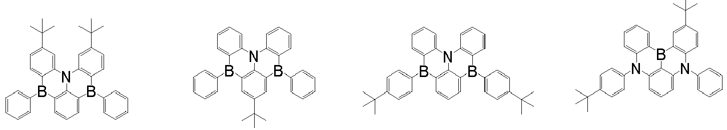

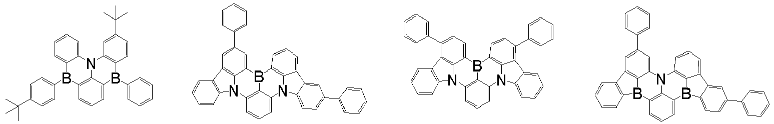

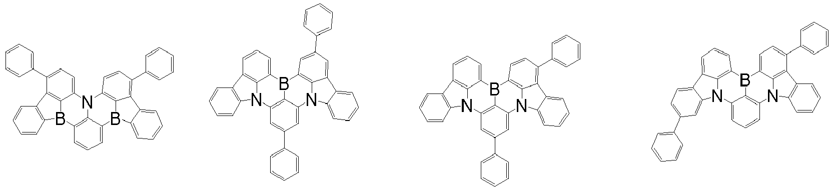

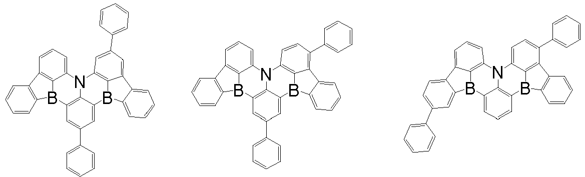

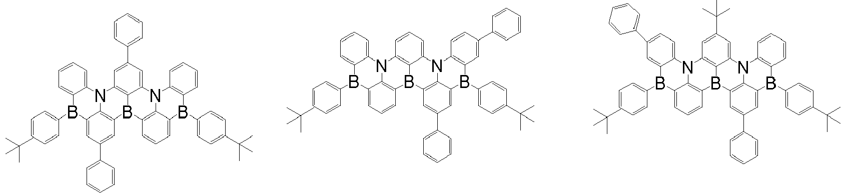

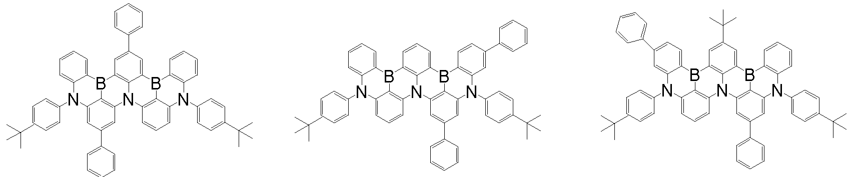

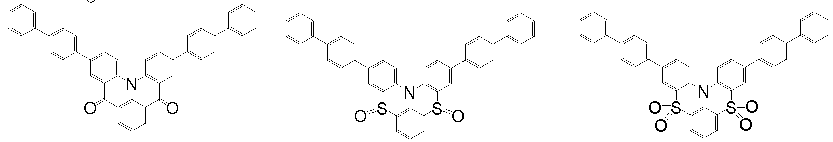

In a preferred embodiment, the electroluminescent unit of the light emitting device according to the present invention is selected from: an OLED (organic light emitting diode), a TFT-LCD (thin-film transistor liquid crystal display), a LED (light emitting diode), a QLED (quantum dot light emitting device), an OLEC (organic light emitting electrochemical cell), an OLET (organic light emitting transistor), a PeLED (perovskite light emitting device), a micro-LED (micro-light emitting diode), or other light emitting devices.

In a more preferred embodiment, the electroluminescent unit of the light emitting devices of the present invention is selected from OLEDs;

In another more preferred embodiment, the electroluminescent unit of the light emitting device according to the present invention is selected from LEDs.

In a preferred embodiment, the colour conversion layer of the light emitting device according to the present invention can absorb the light of the wavelength I and emit the light of wavelength II.

In a preferred embodiment, in the light emitting device of the present invention, the emission spectrum of the electroluminescent unit and the light absorption spectrum of the CCM at least partially overlap.

In a preferred embodiment, in the light emitting device of the present invention, the emission spectrum of the electroluminescent unit emits UV or blue light.

In a preferred embodiment, the colour conversion layer of the light emitting device according to the present invention emits the light of wavelength II, the FWHM of its spectrum is less than 40 nm, preferably less than 35 nm, more preferably less than 33 nm, and most preferably less than 30 nm.

In a preferred embodiment, the colour conversion layer of the light emitting device according to the present invention can be either an uniform thin layer or a patterned thin layer with a thickness of 20 nm to 20 µm, preferably less than 15 µm, more preferably less than 12 µm, even more preferably less than 10 µm, particularly preferably less than 8 µm, further preferably less than 6 µm, and most preferably less than 4 µm.

In a preferred embodiment, the colour conversion layer of the light emitting device according to the present invention can be prepared by vapor deposition, ink-jet printing, screen printing, gravure printing, post-coating photolithography, or other methods.

Taking vapor deposition as an example, where the colour conversion material is placed into a heating crucible of the vacuum thermal evaporator, and heated under a vacuum of 1E-7Pa to vaporize. The vapor of the colour conversion material then deposites onto the substrate to form a colour conversion film. The deposition thickness can be controlled by tuning the evaporation rate and time, and specific patterns could be formed by using a mask.

In some embodiments, in the colour conversion layer (CCL) of the present invention do not comprise any polymers or resins. Preferably, the colour conversion layer is processed by the vapor deposition method as described above.

The colour conversion layer can also be processed by inkjet printing, transfer printing, photolithography, or the like. In those cases, the colour conversion materials of the present invention should be dissolved in an organic solvent alone or together with other materials to form inks.

The present invention further relates to a formulation or a printing ink. The formulation comprises at least one of the colour conversion materials as described above, and at least one organic solvent. The at least one organic solvent is selected from aromatic, heteroaromatic, esters, aromatic ketones, aromatic ethers, aliphatic ketones, aliphatic ethers, alicyclic, olefins, boronic esters, phosphoric esters, or mixtures of two or more of them.

In a preferred embodiment, in the formulationof the present invention, the at least one organic solvent are selected from aromatic or heteroaromatic-based solvents.

Examples of aromatic or heteroaromatic-based solvents suitable for the present invention include, but are not limited to: p-diisopropylbenzene, amylbenzene, tetralin, cyclohexylbenzene, chloronaphtalene, 1,4-dimethylnaphthalene, 3-isopropylbenzene, p-methylisopropylbenzene, dipentylbenzene, tripentylbenzene, pentyltoluene, o-diethylbenzene, m-diethylbenzene, p-diethylbenzene, 1,2,3,4-tetramethylbenzene, 1,2,3,5-tetramethylbenzene, 1,2,4,5-tetramethylbenzene, butylbenzene, dodecylbenzene, dihexylbenzene, dibutylbenzene, p-diiisopropylbenzene, cyclohexylbenzene, benzylbutylbenzene, dimethylnaphthalene, 3-isopropylbiphenyl, p-methylisopropylbenzene, 1 -methylnaphthalene, 1,2,4-tri chlorobenzene, 4,4-difluorobenzenem ethane, 1,2-dimethoxy-4-(1-propenyl) benzene, diphenylmethane, 2-phenylpyridine, 3 -phenylpyridine, N-methyldiphenylamine, 4-isopropylbipheny, 1,1,1 -bis(3,4-dimethylphenyl) ethane, 2-isopropylnaphthalene, quinoline, isoquinoline, methyl 2-furanecarboxylate, ethyl 2-furanicarboxylate, and the like.

Examples of aromatic ketone-based solvents suitable for the present invention include, but are not limited to: 1-tetrahydronaphthalone, 2-tetrahydronaphthalone, 2-(phenylepoxy)tetrahydronaphthalone, 6-(methoxy)tetrahydronaphthalone, acetophenone, phenylacetone, benzophenone, and derivatives thereof such as 4-methyl acetophenone, 3-methyl acetophenone, 2-methyl acetophenone, 4-methyl propanone, 3-methyl propanone, 2-methyl propanone, and the like.

Examples of aromatic ether-based solvents suitable for the present invention include, but not limited to: 3-phenoxytoluene, butoxybenzene, p-anisaldehyde dimethyl acetal, tetrahydro-2-phenoxy-2H-pyran, 1,2-dimethoxy-4-(1-propenyl)benzene, 1,4-benzodioxane, 1,3-dipropylbenzene, 2,5-dimethoxytoluene, 4-ethylphenyl ether, 1,3-dipropoxybenzene, 1,2,4-trimethoxybenzene, 4-(1-propenyl)-1,2-dimethoxybenzene, 1,3-dimethoxybenzene, glycidyl phenyl ether, dibenzyl ether, 4-tert-butyl anisole, trans-anethole, 1,2-dimethoxybenzene, 1-methoxynaphthalene, diphenyl ether, 2-phenoxymethyl ether, 2-phenoxytetrahydrofuran, ethyl-2-naphthyl ether.

In some preferred embodiments, in the formulation of the present invention, the at least one organic solvent can be selected from aliphatic ketones, such as, 2-nonanone, 3-nonanone, 5-nonanone, 2-decanone, 2,5-hexanedione, 2,6,8-trimethyl-4-nonanone, fenchone, phoron, isophorone, di-n-amyl ketone, and the like; and the at least one organic solvent of the present invention can be selected from aliphatic,ethers, such as, dipentyl ether, hexyl ether, dioctyl ether, ethylene glycol dibutyl ether, diethylene glycol diethyl ether, diethylene glycol butyl methyl ether, diethylene glycol dibutyl ether, triethylene glycol dimethyl ether, triethylene glycol ethyl methyl ether, triethylene glycol butyl methyl ether, tripropylene glycol dimethyl ether, tetraethylene glycol dimethyl ether, and the like.

In other preferred embodiments, in the formulation of the present invention, the at least one organic solvent can be selected from: ester-based solvents including alkyl octanoate, alkyl sebacate, alkyl stearate, alkyl benzoate, alkyl phenylacetate, alkyl cinnamate, alkyl oxalate, alkyl maleate, alkyl lactone, alkyl oleate, and the like. Particular preferred as octyl octanoate, diethyl sebacate, diallyl phthalate or isononyl isononanoate.

The solvent can be used alone or as mixtures of two or more organic solvents.

In certain preferred embodiments, in the formulation of the present invention can further comprise another organic solvent. Examples of another organic solvent include, but are not limited to: methanol, ethanol, 2-methoxyethanol, dichloromethane, trichloromethane, chlorobenzene, o-dichlorobenzene, tetrahydrofuran, anisole, morpholine, toluene, o-xylene, m-xylene, p-xylene, 1,4 dioxane, acetone, methyl ethyl ketone, 1,2 dichloroethane, 3-phenoxytoluene, 1,1,1-trichloroethane, 1,1,2,2-tetrachloroethane, ethyl acetate, butyl acetate, dimethylformamide, dimethylacetamide, dimethylsulfoxide, tetrahydronaphthalene, decalin, indene, and/ or mixtures thereof.

In some preferred embodiments, particularly suitable solvents for the present invention are solvents with Hansen solubility parameters in the following ranges:
δd (dispersion force) is in the range of 17.0 to 23.2 MPa^{1/2}, especially in the range of 18.5 to 21.0 MPa^{1/2};
δp (polarity force) is in the range of 0.2 to 12.5 MPa^{1/2}, especially in the range of 2.0 to 6.0 MPa^{1/2};
6h (hydrogen bonding force) is in the range of 0.9 to 14.2 MPa^{1/2}, especially in the range of 2.0 to 6.0 MPa^{1/2}.

In the formulation of the present invention, the boiling points of the organic solvent should be taken into consideration for the selection. In the present invention, the boiling points of the organic solvent ≥150°C; preferably ≥180°C; more preferably ≥200°C; further more preferably ≥250°C; and most preferably ≥275°C or ≥300°C. The boiling points in these ranges are beneficial in terms of preventing nozzle clogging of the inkjet printhead. The organic solvent can be evaporated to form a functional material film.

In a preferred embodiment, the formulation of the present invention is a solution.

In another preferred embodiment, the formulation of the present invention is a dispersion.

The present invention also relates to the use of the formulation as coatings or printing inks in the preparation of organic electronic devices, particularly preferably by printing or coating processing methods.

Suitable printing or coating techniques include, but are not limited to, ink-jet printing, nozzle printing, typographic printing, screen printing, dip coating, spin coating, blade coating, roller printing, torsion roll printing, planographic printing, flexographic printing, rotary printing, spray printing, brush coating, pad printing, slit die coating, and so on. Preferred techniques are gravure printing, nozzle printing and ink-jet printing. The solution or dispersion may additionally comprise one or more components, such as surfactants, lubricants, wetting agents, dispersing agents, hydrophobic agents, binders, etc, which are used to adjust the viscosity and film forming properties, or to improve adhesion, etc. For more information about printing technologys and their requirements for solutions, such as solvent, concentration, viscosity, and the like, please refer to "Handbook of Print Media: Technologies and Production Methods", edited by Helmut Kipphan, ISBN 3-540-67326-1.

The preparation methods as described above, wherein the formed functional layer has a thickness of 5 nm-1000 nm.

The colour conversion material of the present invention appears in the ink with a concentration (by mass) of no less than 0.1 wt%. The colour conversion efficiency of the colour conversion layer can be improved by adjusting the concentration of the colour conversion material in the ink and the thickness of the colour conversion layer. In general, the higher the concentration of the colour conversion material or the thickness of the layer, the higher the colour conversion rate of the colour conversion layer would be.

The formulation of the present invention further comprises a polymer additive, which may be selected from, but not limited to the following materials: polyethylene, polypropylene, polystyrene, polycarbonate, polyacrylate, polyvinylpyrrolidone, polyvinyl alcohol, polyvinyl acetate, polyethylene glycol, polysiloxane, polyacrylonitrile, polyvinyl chloride, polyvinylidene chloride, polyethylene terephthalate, polybutylene terephthalate, polyvinyl butyrate, polyamide, polyoxymethylene, polyimide, polyether-ether-ketone, polysulfone, polyarylether, polyaramide, cellulose, modified cellulose, acetate, nitrocellulose, or the mixtures thereof.

Salts are difficult to be purified, and contains impurities, which may often influence the opto-elecrtonic performance of the device. In some preferred embodiments, for the purposes of the present invention, the colour conversion layer (CCL) does not comprise any salts, and the colour conversion layer preferably does not comprise any organic acid salts formed by organic acids and metals. In terms of cost, the present invention preferably excludes organic acid salts with transition metals or lanthanide elements.

In a particularly preferred embodiment, the electroluminescent unit of the light emitting device is a LED.

In another particularly preferred embodiment, the electroluminescent unit of the light emitting devices is an OLED comprising a substrate, an anode, at least one light emitting layer, and a cathode.

The substrate should be opaque or transparent. A transparent substrate could be used to produce a transparent light emitting device (for example: Bulovic et al. , Nature 1996, 380, p29, and Gu et al. , Appl. Phys. Lett. 1996, 68, p2606). Substrates may be either rigid or elastic. Preferably, the substrates should have a smooth surface. A substrate free of surface defects is particularly desirable. In a preferred embodiment, the substrates are flexible and can be selected from a polymer film or plastic with a glass transition temperature Tg over 150 °C, preferably over 200 °C, more preferably over 250 °C, and most preferably over 300 °C. Examples of the suitable flexible substrates include poly (ethylene terephthalate) (PET) and polyethylene glycol (2,6 - naphthalene) (PEN).

The choice of anodes may include a conductive metal, a metal oxide, or a conductive polymer. The anode should be able to easily inject holes into a hole-injection layer (HIL) or a hole-transport layer (HTL), or a light emitting layer. In one embodiment, the absolute value of the difference between the work function of the anode and the HOMO energy level of the emitter of the emitting layer, or the highest occupied molecular orbital (HOMO) energy level! valence band energy level of the p-type semiconductor material for the hole injection layer (HIL)/ hole transport layer (HTL)/ electron blocking layer (EBL) is less than 0.5 eV, preferably less than 0.3 eV, more preferably less than 0.2 eV. Examples of anode materials may include, but are not limited to: Al, Cu, Au, Ag, Mg, Fe, Co, Ni, Mn, Pd, Pt, ITO, aluminum doped zinc oxide (AZO), and the like. Other suitable anode materials are known and can be readily selected for use by one of ordinary skill in the art. The anode material can be deposited using any suitable technique, such as a suitable physical vapor deposition method, including RF magnetron sputtering, vacuum thermal evaporation, e-beam, etc. In some embodiments, the anode is patterned. Patterned conductive ITO substrates are commercially available and can be used to produce the devices of the present invention.

The choice of cathode may include a conductive metal and a metal oxide. The cathode should be able to easily inject electrons into the EIL, the ETL, or the directly into the emitting layer. In one embodiment, the absolute value of the difference between the work function of the cathode and the lowest unoccupied molecular rrbital (LUMO) energy level of the emitter of the emitting layer, or the LUMO energy level! conduction band energy level of the n-type semiconductor material for electron injection layer (EIL)/ electron transport layer (ETL)/ hole blocking layer (HBL) is less than 0.5 eV, preferably less than 0.3 eV, most preferably less than 0.2 eV. In principle, all materials that may be used as cathodes for OLEDs are possible to apply as cathode materials for the present invention. Examples of cathode materials include, but are not limited to: Al, Au, Ag, Ca, Ba, Mg, LiF/ Al, MgAg alloys, BaF₂/ Al, Cu, Fe, Co, Ni, Mn, Pd, Pt, ITO, and the like. The cathode material can be deposited using any suitable technique, such as the suitable physical vapor deposition method, including RF magnetron sputtering, vacuum thermal evaporation, e-beam, and the like.

The OLED device may also comprise other functional layers, such as a hole injection layer (HIL), a hole transport layer (HTL), an electron blocking layer (EBL), an electron injection layer (EIL), an electron transport layer (ETL), and a hole blocking layer (HBL). Materials suitable for use in these functional layers are described in details above and in WO2010135519A1, US20090134784A1 and WO201110277A1. The entire contents of the these three documents are incorporated herein by reference in their entirety.

In the light emitting device of the present invention, the emitting wavelength of the light emitting device is between 300 nm and 1000 nm, preferably between 350 nm and 900 nm, more preferably between 400 nm and 800 nm.

The present invention also relates to the application of the light emitting device according to the present invention in various electronic devices, including but are not limited to, display device, lighting device, light source, sensor, and the like.

The present invention further provides a display device, comprising a number of sub-pixels, at least one of the sub-pixel comprising the above-mentioned light emitting device.

Preferably, either the red sub-pixel or the green sub-pixel of the display device comprises the light emitting devices as described above.

In a particularly preferred embodiment, the display device is a multi-colour display device, and the display device with narrow-FWHM comprising at least two types of the emitting devices selected from the red, the green or the blue light emitting devices as pixels, different pixels are arranged altematinvely into array to form a display panel.

The present invention will be described below in conjunction with the preferred embodiments, but the present invention is not limited to the following embodiments. It should be understood that the scope of the present invention is covered by the scope of the claims of the present invention, and those skilled in the art should understand that certain changes may be made to the embodiments of the present invention.

### Examples

### Example 1: red narrow-FWHM light emitting device.

The red colour conversion layer comprises the molecule of the following structure:

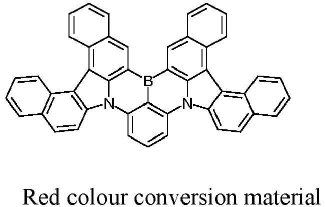

Molecules of the above structure were placed into the heated crucible of the vacuum thermal evaporation device, and the molecules were evaporated and deposited onto the glass side of the green OLED device at a vacuum degree of 1E-7 Pa, so that the red colour conversion layer with a thickness of 100 nm was formed.

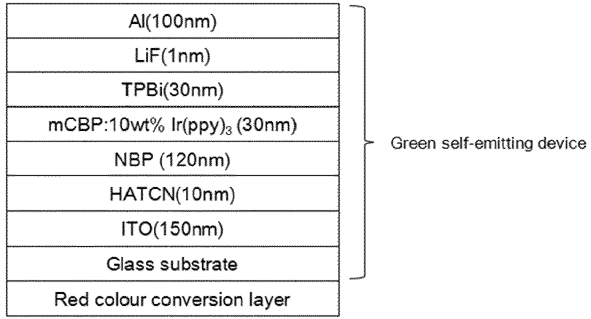

The present embodiment further provided a structure of the green OLED light emitting device, wherein the anode electrode is an ITO layer;

The hole injection layer was a layer of HATCN (Dipyrazino[2,3-f:2',3'-h]quinoxaline-2,3,6,7,10,11-hexacarbonitrile);

The hole transport layer was a layer of NPB (N, N'-bis(1-naphthalenyl-N, N'-bisphenyl-(1,1'-biphenyl)-4,4'-diamine) layer;

The light emitting layer was a doped layer of Ir(ppy)3 (tris(2-phenylpyridinato-C2,N)iridium(III)) with CBP (4,4'-Bis(9-carbazolyl)-1,1'-biphenyl).

The electron transport layer was a layer of TPBI (1,3,5 - tris (1 - phenyl-1 H-benzimidazol-2 - yl) benzene).

Example 2: As a convertible embodiment of the present invention, the structure of the red narrow half-peak light emitting device was not limited thereto. As long as the red color conversion layer described in the present invention was applied, the purpose of the present invention can be achieved and falls within the scope of protection of the present invention.

### Example 3: green colour converter.

The colour conversion layer of the green sub-pixel contains the molecule of the following structure:

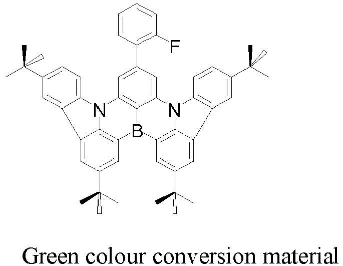

Molecules of the above structure were dissolved in methyl acrylate at 2%wt, a thin film with a thickness of 10 µm was formed on the surface of the blue GaN LED substrate by coating. After being irradiated with 365 nm ultraviolet light for 5 minutes, the methyl acrylate was polymerized to form the solid thin film, i. e. the colour conversion layer. The colour conversion layer can absorb blue light from GaN LEDs with a peak between 400-465 nm and emit green light between 490-530 nm with a colour coordinate of (0.16, 0.60).

In order to achieve multi-colour display by using the colour converters to simultaneously realize multi-colour emission, the present invention also provides multiple additional display technology solutions.

The first display technical scheme is shown as follows:

| | | | |
|---|---|---|---|
| | Polarizer | | |
| | Blue Colour Filter | Green Colour Filter | Red Colour Filter |
| | Polarizer | | |
| | LCD Module | | |
| | Polarizer | | |
| | Red, Green and Blue Color Conversion Layer | | |
| GaN LED Edge-lit | Light Guide Plate | | |

A red, green and blue three-colour colour conversion layer was added on the top of a light guide plate of a liquid crystal display, and the colour conversion layer comprises the following three molecules:

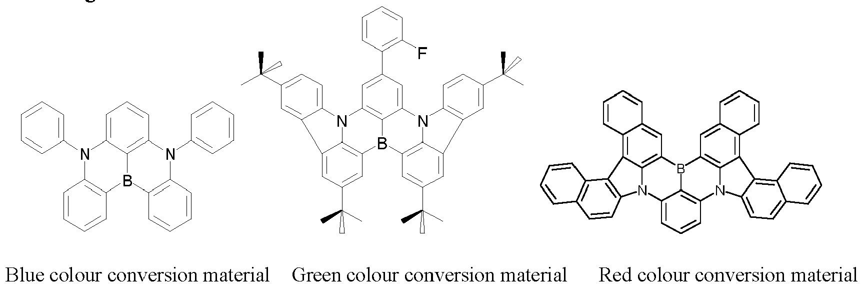

A preparation method of the colour conversion layer is described as follows:
The above blue colour conversion material, green colour conversion material and red colour conversion material were dissolved in a mixture solvent of tetrahydronaphthalene: toluene = 3:2 in the ratio of 5mg/ml, 3mg/ml and 2mg/ml respectively. At the same time, 15 mg/ml of the polystyrene, 5 mg/ml of silicon dioxide nanospheres of 3-5 µm in diameter were added into the solution to form the ink. Through slit coating using the ink, a solid thin film with a thickness of about 100 um was formed on the surface of the electroluminescent device or a thin film as the colour conversion layer for red, green and blue colours.

The second display technology scheme is shown as follows:

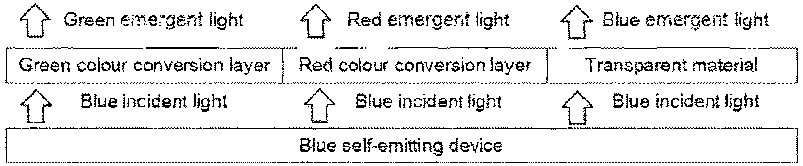

A red, green and blue three-colour display device, comprising the following components:
The green colour converter, the red colour converter and the transparent film layer are arranged alternately into an array to form three types of pixels;
A blue self-emitting device was disposed below the above three film layers, the blue self-emitting device emits blue light with an emission peak between 400 nm and 490 nm, with the blue light emits toward the green colour converter, the red colour converter and the transparent film layer, respectively; through the green colour converter, a green emission with the emission peak between 490 nm and 550 nm is generated; through the red colour converter, a red emission with the emission peak between 550 nm and 700 nm is generated; through the transparent film layer, the blue light with the emission peak between 400 nm and 490 nm remains;
The blue self-emitting device being used in the present embodiment is a organic electroluminescent device, with the structure of: Ag(16 nm)/ Yb(1 nm)/ TPBi(30 nm)/ 26 DCzPPY: 10 wt% FirPic(30 nm)/ NPB(180 nm)/ HATCN(10 nm)/ ITO(10 nm)/Ag(100 nm).
wherein the anode electrode is an ITO layer;
The hole injection layer is a HATCN (Dipyrazino[2,3-f:2',3'-h]quinoxaline-2,3,6,7,10,11-hexacarbonitrile) layer;

The hole transport layer is the a NPB (N, N'-bis(1-naphthalenyl)-N, N'-bisphenyl-(1,1'-biphenyl)-4,4'-diamine) layer; the light emitting layer is a layer of FirPic bis[2-(4,6-difluorophenyl)pyridinato-C2,N](picolinato)iridium(III) and 26DCzPPY (2,6-bis(3-(9H-carbazol-9-yl)phenyl)pyridine); the electron transport layer is a layer of TPBi (1,3,5-tris(1-phenyl-1H-benzimidazol-2-yl)benzene).

For the purposes of the present invention, the structure of the display devices are not limited thereto, and as long as the display technical solution of the present invention is applied, the purposes of the present invention can be achieved, and the convertible embodiments fall within the scope of protection of the present invention.

It should be noted that the above two techniques only describe the structure of the narrow-FWHM light emitting devices in the display device of the present invention. In order to achieve the complete display effect, a display device should also include, and may not be limited to, the following components:
1) The thin-film transistors set below the narrow-FWHM light emitting device and connected to the self-emitting part of the light emitting devices through a circuit, which serve to control the brightness.
2) The pixel circuits set below the thin-film transistor, which serve to control each pixel on the array, so as to display a pattern.
3) The substrate set below in the pixel circuit, which provides mechanical support for all the above-mentioned narrow-FWHM light emitting devices, the thin-film transistors and the pixel circuits.

For further description of using the colour conversion layers to realize multicolour light display, please refer to the following technical materials: Chinese patents CN102067729B and CN106556949B.

## Claims

1. A light emitting device, comprising an electroluminescent unit and a colour conversion layer, wherein the colour conversion layer comprises at least one colour conversion material having a structural unit of formula (1) or (2): 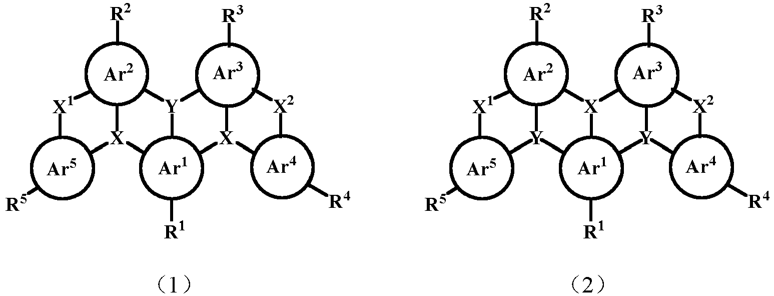 wherein:
each X is selected from N, C(R⁶), Si(R⁶); each Y is selected from B, P=O, C(R⁶), Si(R⁶);
each of Ar¹ to Ar³ is independently selected from an aromatic group containing 5 to 24 ring atoms, or a heteroaromatic group containing 5 to 24 ring atoms;
each of Ar⁴ to Ar⁵ is independently selected from null, an aromatic group containing 5 to 24 ring atoms, or a heteroaromatic group containing 5 to 24 ring atoms;
when neither Ar⁴ nor Ar⁵ is null, each X is selected from N, C(R⁶), or Si(R⁶), each Y is selected from B, P=O, C(R⁶), or Si(R⁶);
when Ar⁴ and/ or Ar⁵ is null, the corresponding X and Y are each independently selected from N(R⁶), C(R⁶R⁷), Si(R⁶R⁷), C=O, O, C=N(R⁶), C=C(R⁶R⁷), P(R⁶), P(=O)R⁶, S, S=O, or SO₂;
each of X¹ and X² is independently null or a bridging group;
R¹ to R⁷ are independently selected from the group consisting of H, D, -F, -Cl, Br, I, -CN, -NO₂, -CF₃, B(OR₂)₂, Si(R₂)₃, a C₁-C₂₀ linear alkyl group, a C₁-C₂₀ linear haloalkyl group, a C₁-C₂₀ linear alkoxy group, a C₁-C₂₀ linear thioalkoxy group, a C₃-C₂₀ branched/ cyclic alkyl group, a C₃-C₂₀ branched/ cyclic haloalkyl group, a C₃-C₂₀ branched/ cyclic alkoxy group, a C₃-C₂₀ branched/ cyclic thioalkoxy group, a C₃-C₂₀ branched/ cyclic silyl group, a C₁-C₂₀ ketone group, a C₂-C₂₀ alkoxycarbonyl group, a C₇-C₂₀ aryloxycarbonyl group, a cyano group, a carbamoyl group, a haloformyl group, a formyl group, an isocyano group, an isocyanate group, a thiocyanate/ isothiocyanate group, a hydroxyl group, a nitro group, a CF₃ group, a substituted/ unsubstituted aromatic! heteroaromatic group containing 5 to 40 ring atoms, an aryloxy/ heteroaryloxy group containing 5 to 40 ring atoms, an arylamine/ heteroarylamine group containing 5 to 40 ring atoms, and a disubstituted unit in any position of the above substituents or a combination thereof, wherein one or more of the substituent groups can form a monocyclic or polycyclic aliphatic or aromatic ring system with each other and/ or with the ring bonded to the groups.

2. The light emitting device of claim 1, wherein the colour conversion layer comprises at least one the colour conversion material having a structure unit of formula (1a) or (2a). 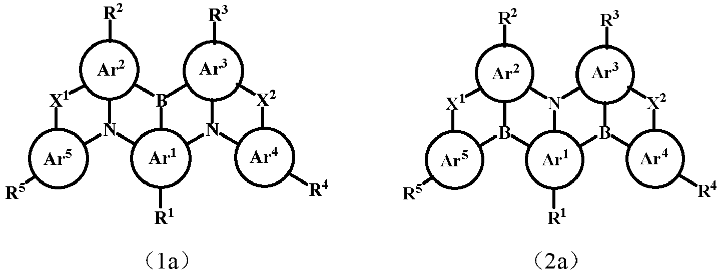 wherein Ar¹ to Ar⁵ , R¹ to R⁵, X¹ to X² are same as those defined in claim 1.

3. The light emitting device of claim 1, wherein each of Ar¹, Ar², Ar³, Ar⁴, and Ar⁵ in the formula (1) or (2) is independently selected from the following structural formulae: 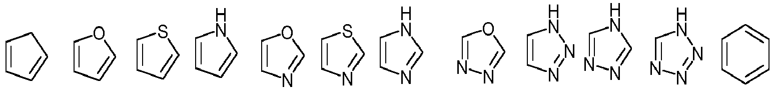 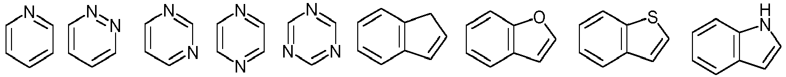 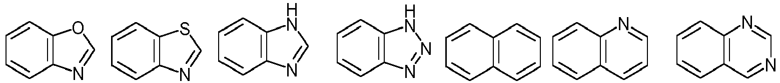 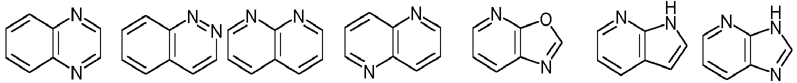 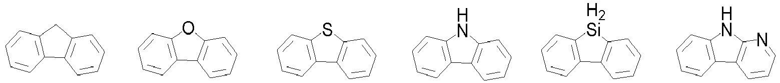 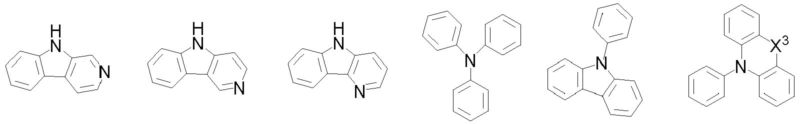 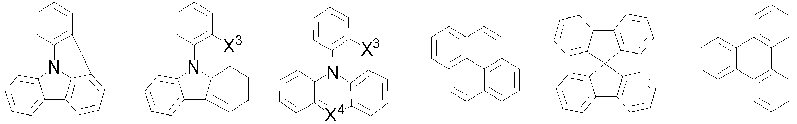 wherein each of X³ and X⁴ is independently null or a bridging group.

4. The light emitting device of claim 1, wherein the colour conversion material is selected from the following structural formulae:

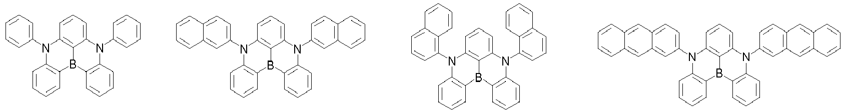

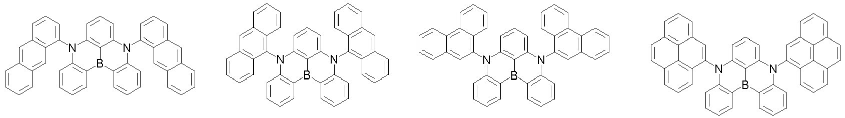

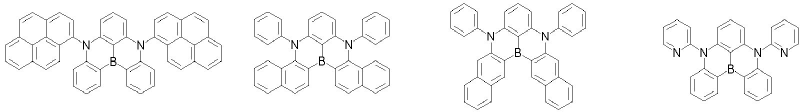

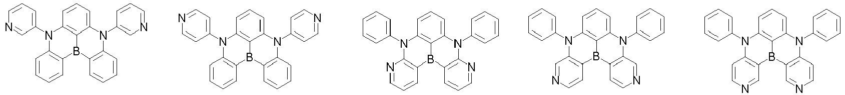

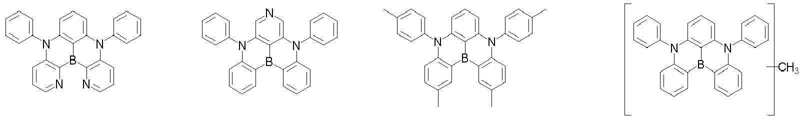

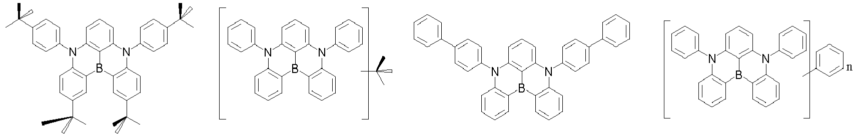

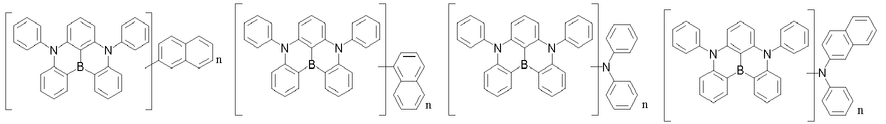

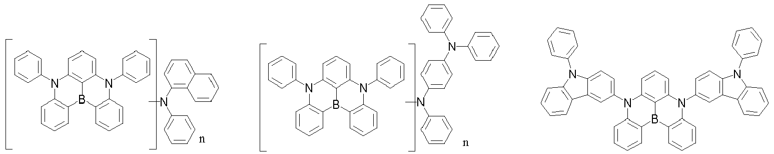

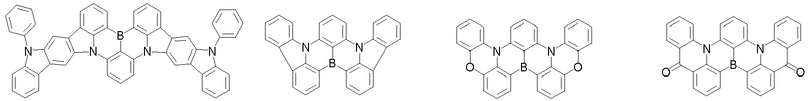

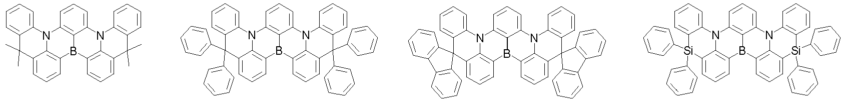

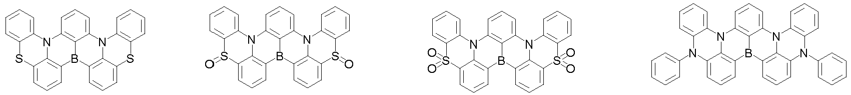

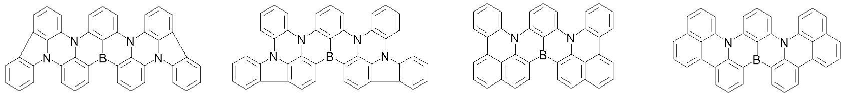

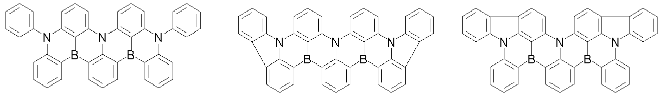

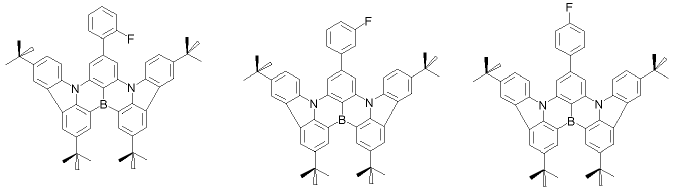

5. The light emitting device of claim 1, wherein the electroluminescent unit is selected from: an OLED, a TFT-LCD, a LED, a QLED, an OLEC, an OLET, a PeLED, or a micro-LED.

6. The light emitting device of claim 1, wherein the colour conversion layer can absorb the light of wavelength I and emit the light of wavelength II.

7. The light emitting device of claim 1, wherein the emission spectrum of the electroluminescent unit at least partially overlaps with the absorption spectrum of the colour conversion material.

8. The light emitting device of claim 1, wherein the electroluminescent unit emits UV or blue light.

9. The light emitting device of claim 6, wherein the FWHM of the spectrum of wavelength II emitted by the colour conversion layer is less than 40 nm.

10. The light emitting device of claim 1, wherein the colour conversion layer can be either an uniform thin layer or a patterned thin layer with a thickness of 20 nm to 20 µm.

11. The light emitting device of claim 1, wherein the colour conversion layer can be prepared by vapor deposition, ink-jet printing, screen printing, gravure printing, or post-coating photolithography.

12. A display device, comprising a number of sub-pixels, at least one of the sub-pixels comprising a light emitting device according to claim 1.

13. The display device of claim 11, wherein either the red sub-pixel or the green sub-pixel comprises a light emitting devices according to claim 1.

14. A multi-colour display device, comprising at least two types of the light emitting devices selected from the red, the green or the blue light emitting devices according to claim 8 as pixels, different pixels are arranged alternatively into array to form a display panel.
